# EUROPÄISCHE PATENTSCHRIFT

(11) **EP 0 247 397 B1**
(45) Veröffentlichungstag und Bekanntmachung des Hinweises auf die Patenterteilung: **02.03.1994**
(21) Anmeldenummer: 87106534.8
(22) Anmeldetag: 06.05.1987
(51) Int. Cl.: H01J 37/32, H01J 37/305

(54) **Vorrichtung zur Oberflächenbehandlung von Werkstücken**
Apparatus for the surface treatment of work pieces
Dispositif à traitement de surface de pièces à usiner

(30) Priorität: 06.05.1986 DE 3615361
(43) Veröffentlichungstag der Anmeldung: 02.12.1987
(73) Patentinhaber: dos Santos Pereira Ribeiro, Carlos Antonio, Dipl.-Ing., D-72459 Albstadt (DE)
(72) Erfinder: dos Santos Pereira Ribeiro, Carlos Antonio, Dipl.-Ing., D-72459 Albstadt (DE)
(74) Vertreter: Vogeser, Werner, Dipl.-Ing.

(56) Entgegenhaltungen:
- DE-A- 2 625 870
- FR-A- 2 435 810
- US-A- 4 131 506
- Patent Abstracts of Japan, unexamined applications, E Field, Band 9,12, Nr. 136, 12. Juni 1985; The Patent Office Japanese Government, Seite 84 E 320 & JP-A-60-20 440

## Beschreibung

Die Erfindung betrifft eine Vorrichtung zur Oberflächenbehandlung, insbesondere zum Ätzen und/oder Beschichten von Werkstücken mittels Ionenbeschuß nach dem Oberbegriff des Anspruches 1.

Eine derartige Vorrichtung zur Oberflächenbehandlung, wie beispielsweise zum Ätzen und/oder Beschichten von Werkstücken mittels Ionenbeschuß ist aus der FR-A-2 435 810 bekannt. Diese bekannte Vorrichtung zur Oberflächenbehandlung umfaßt mindestens eine eine Glühkadode umfassende Ionisationskammer, in die Gasatome zur Niedervolt-Bogenentladung zwischen Ionisationskammer und mindestens einer Anode in eine Behandlungskammer eingeleitet werden, die an eine Vakuumpumpe angeschlossen ist. Es ist ferner wenigstens eine Magnetspule vorhanden zur Steuerung der Ionendichte in der Niedervolt-Bogenentladung. Gemäß einer Ausführungsform dieser bekannten Vorrichtung kann wenigtens ein Werkstück seitlich von einem Plasmastrom angeordnet werden, wobei dieser Plasmastrom durch die wenigstens eine Magnetspule gesteuert wird. Diese wenigstens eine Magentspule ist innerhalb der Behandlungskammer angeordnet. Bei dieser bekannten Vorrichtung kann jedoch nur eine Fläche, und zwar die dem Plasmastrom zugewandte Fläche eines Werkstücks oberflächenbehandelt werden, da das Werkstück effektiv nicht vollständig innerhalb der Behandlungskammer angeordnet ist, sondern von außerhalb mit Hilfe einer Werkstückshalterung in einen Behandlungsschacht seitlich in die Kammer eingeführt wird. Dabei befindet sich der eigentliche zu behandelnde Bereich des Werkstücks, nämlich seine vordere Fläche jedoch in radialer Richtung innerhalb der wenigstens einen Magnetspule.

Aus Patent Abstracts of Japan, Unexamined Applications, E. Field, Band 9, Nr. 136, 12. Juni 1985, The Patent Office Japanese Government, Seite 84 (E-320), Kokai-Nr. 60-20440 und JP-A2-60-20440, ist eine Vorrichtung zur Oberflächenbehandlung bekannt, bei der die Kathode in einer getrennten Ionisationskammer angeordnet ist, wobei sich die Ionisationskammer an eine Behandlungskammer anschließt. Die Ionisationskammer ist gegenüber der Behandlungskammer durch ein Gitter getrennt.

Die der Erfindung zugrundeliegende Aufgabe besteht darin, eine Vorrichtung zur Oberflächenbehandlung der angegebenen Gattung zu schaffen, welche die Möglichkeit bietet, eine besonders gleichmäßige Oberflächenbehandlung von Werkstücken, und zwar von im wesentlichen der gesamten Werkstückoberfläche, in einem einzigen Arbeitsgang zu erreichen.

Diese Aufgabe wird erfindungsgemäß durch die im Kennzeichnungsteil des Anspruches 1 aufgeführten Merkmale gelöst.

Demnach besteht die Erfindung darin, daß während des Betriebs die zu behandelnden Werkstücke außerhalb des starken Magnetfelds der wenigstens einen Magnetspule in der Behandlungskammer angeordnet sind und daß ferner die Werkstücke derart in der Behandlungskammer angeordnet werden, daß sie eine allseitige Oberflächenbehandlung erfahren.

Durch diese spezifische Anordnung der Werkstücke befinden sich diese in vorteilhafter Weise praktisch außerhalb des Einflusses der Magnetfelder, welche durch die wenigstens eine Magnetspule erzeugt werden, die zwischen der Glühkathode und der dieser zugeordneten Anode angeordnet ist. Wegen der wandparallelen bzw. entladungsparallelen Anordnung der Werkstücke eignet sich die Vorrichtung nach der Erfindung darüber hinaus auch als Durchlaufanlage.

Gemäß einer vorteilhaften Ausgestaltung der Erfindung werden mindestens zwei Magnetspulen verwendet, wobei eine erste Magnetspule austrittsseitig an der Ionisationskammer angeordnet ist, während die zweite Magnetspule im wesentlichen mittig zwichen der ersten Magnetspule und der zugehörigen Anode angeordnet ist.

Zur gleichzeitigen Behandlung einer Vielzahl von nebeneinander angeordneten Werkstücken bzw. zur Behandlung eines langgestreckten Werkstücks eignet sich besonders eine erfindungsgemäße Vorrichtung, deren Ionisationskammer wenigstens zwei Ionenstrahlaustritte aufweist, denen jeweils eine eigene Anode zugeordnet ist, die dem jeweiligen Ionenstrahlaustritt gegenüberliegt.

Gemäß einer weiteren vorteilhaften Ausgestaltung der Erfindung ist die Ionisationskammer elektrisch isoliert von der Behandlungskammer angeordnet und besteht aus mindestens zwei Teilen, wobei ein erster Teil die Kühlmittel- und Stromdurchführungen für die Glühkathode enthält, und wobei das zweite Teil die Kühlmittel- und Stromdurchführungen für die Magnetspule umfaßt, die der Ionisationskammer nachgeordnet ist. Direkt anschließend an die Ionenstrahlaustrittsöffnung befindet sich die erste Magnetspule, so daß die Bogenentladung an dieser Stelle stark eingeschnürt und damit die Gasionisation entsprechend aktiviert wird. Durch diese Anordnung läßt sich die benötigte Einschnürung der Bogenentladung mit einem relativ geringen Erregungsstrom für die Spule realisieren.

Der Strom innerhalb der Bogenentladung beträgt 100 A und mehr, so daß sowohl die Anode bzw. die Anoden und die vakuumdicht in der Behandlungskammer angeordneten Magnetspulen einer geeigneten Kühlung bedürfen. Zu diesem Zweck werden die Magnetspulen mindestens auf der Wicklungsinnenseite durch einen wassergekühlten Ring gekühlt. Die Anode oder die Anoden sind ebenfalls wassergekühlt, wobei die Kühlfläche auf der Anodenrückseite der Bogenentladung abgewandt vorgesehen ist.

Die Ionendichte des Entladungsbogens läßt sich durch Änderung der Magnetfeldstärke einstellen bzw. für eine gleichmäßige Ionenextraktion aus der Gasentladung optimieren. Die Magnetfeldstärke läßt sich entweder durch Variation der die Magnetspulen durchfließenden Ströme oder bzw. und durch eine axiale Verschiebung der Magnetspulen zueinander bzw. zum Plasma der Entladung variieren. Von Vorteil sind dabei Stromquellen für die Magnetspulen mit hoher Ausgangsimpedanz bzw. mit hohem Ausgangswiderstand, so daß induktive Ströme vom Entladungsbogen durch die Wicklungen nicht entstehen können. Während vorzugsweise jede Magnetspule von einer eigenen Stromquelle gespeist wird, ist zur Speisung einer Vielzahl von Anoden eine einzige, gemeinsame Stromquelle vorgesehen.

Zur gezielten Ionenführung sind die außerhalb des Entladungsbogens und außerhalb des Einflusses der Magnetfelder der Magnetspulen angeordneten Werkstücke vorteilhafterweise an eine regelbare Hilfsspannung anschließbar, wobei diese Hilfsspannung entweder eine hochfrequente Wechselspannung oder eine Gleichspannung ist, die relativ zum Anodenpotential ein negatives Potential aufweist.

Soll die erfindungsgemäße Vorrichtung als Durchlaufanlage verwendet werden, so kann die Anode oder können die Anoden als wassergekühlte Ringanoden ausgebildet sein und die zu behandelnden Werkstücke werden dann unterhalb dieser Ringanode in der Projektion der Ringöffnung vorbeigeführt.

Die erfindungsgemäße Vorrichtung ist jedoch nicht nur für das Ätzen von Werkstückoberflächen mittels Beschuß von Edelgasionen vorteilhaft einsetzbar, vielmehr eignet sich die erfindungsgemäße Vorrichtung in vergleichbar vorteilhafter Weise für das sogenannte reaktive Ätzen von Werkstückoberflächen. Bei diesem an sich bekannten Verfahren werden die in der Ionisationskammer erzeugten Edelgasionen außerhalb der Ionisationskammer mit Reaktivgasen zu einem Mischionenstrahl vermischt. Als Reaktivgase eignen sich beispielsweise Sauerstoff und Stickstoff sowie Kohlenstoff, Bor und/oder Fluor enthaltende Gase.

Bei der erfindungsgemäßen Vorrichtung ist es vorgesehen, die Reaktivgase oder das Reaktivgasgemisch durch Zuführungsleitungen, die im Innenraum der Magnetspulen münden, in die Behandlungskammer einzuführen, wobei sich die Mündung der Zuführungsleitungen in unmittelbarer Nähe des Ionenstrahls befindet. Bei einer besonders vorteilhaften Ausgestaltung der erfindungsgemäßen Vorrichtung unter Verwendung eines Mischionenstrahls ist eine spezielle Kammer der Ionisationskammer nachgeschaltet, und zwar vorteilhafterweise innerhalb der ersten Magnetspule. Diese Kammer ist mit einem Einlaß für das Reaktivgas versehen.

Ihr ist eine weitere Magnetspule zugeordnet. Bei dieser Verbundanordnung von Ionisationskammer und Reaktivgaskammer ist der Gasdruck in letzterer niedriger gehalten als in der Ionisationskammer und höher als in der Behandlungskammer. Sollen mehrere Ionenstrahlen erzeugt werden, so kommt eine Vielzahl von solchen Ionisationskammer-Reaktivgaskammer-Einheiten zum Einsatz.

Bei Verwendung dieser Verbundkammern läuft die Gasionisierung in zwei Phasen ab, wobei in der ersten Phase ein Edelgas, wie beispielsweise Argon, Helium oder Neon kontinuierlich in die Ionisationskammer eingeleitet und dort ionisiert wird. Die Ionen, welche die Ionisationskammer über die Lochblende zur Reaktivgaskammer hin verlassen, werden mit Hilfe der ersten Magnetspule in ihrer Dichte konzentriert und vermischen sich in der Reaktivgaskammer mit den in diese Kammer kontinuierlich eingeführten Gasen, die in einer zweiten Ionisierungsphase ionisiet werden. Eine weitere Einschnürung des Plasmas erfolgt durch die Lochblende der Reaktivgaskammer hinter dieser Lochblende mit Hilfe einer weiteren, zweiten Magnetspule. Die Einstellung der Drücke innerhalb der Kammern erfolgt durch entsprechende Wahl der Öffnungsdurchmesser der Lochblenden und durch Einstellung des Edel- und Reaktivggaspartialdruckes, und zwar unter Berücksichtigung des Saugvermögens der Vakuumpumpe, an die die Behandlungskammer angeschlossen ist.

Vorteilhafterweise ist die Reaktivgaskammer elektrisch isoliert zur Ionisationskammer angeordnet und die beiden Kammern sind auf Schwebepotential gehalten.

Die Vorteile der der Ionisationskammer nachgeschalteten Kammer bestehen darin, daß die Ionisationskammer selbst frei von Reaktivgasen ist, so daß die Glühkathode nicht einem Beschuß mit Reaktivgasionen ausgesetzt ist und damit eine höhere Lebensdauer hat als bei entsprechenden Vorrichtungen gemäß dem Stand der Technik. Außerdem kann der Edelgasdruck in der Ionisationskammer bei Nachschaltung einer Reaktivgaskammer verringert werden, was wiederum die Lebensdauer der Glühkathode positiv beeinflußt. Weiterhin kann der Anteil an ionisierten Gasatomen dadurch wesentlich erhöht werden, daß das Reaktivgas unittelbar in den Bereich der höchsten Ionendichte des Entladungsbogens sowie der höchsten Magnetfeldstärke eingeführt wird. Zudem kann das Verhältnis zwischen Edelgas- und Reaktivgaspartialdrücken auf diese Weise frei eingestellt werden, so daß die übliche Abhängigkeit zwischen den Entladungsparametern, wie beispielsweise der Druck in der Ionisationskammer, Bogenstrom, Anodenspannung und Magnetfeldstärke und den Ätzparametern, wie beispielsweiese der Druck in der Behandlungskammer, Werkstückvorspannung und Ionenstrom zu den Werkstücken, fast vollständig beseitigt ist.

Die vorteilhaften Anwendungsmöglichkeiten der erfindungsgemäß ausgebildeten Vorrichtung werden noch dadurch ergänzt, daß unter Beibehaltung der bereits beschriebenen Vorteile die Beschichtung von Werkstücken aus der Gasphase möglich ist.

Auf diese Weise können z.B. Schichten aus Bornitrit oder Borkarbid auf den Werkstückoberflächen hergestellt werden, indem Bor und Stickstoff bzw. Kohlenstoff enthaltende Gase verwendet werden. Ebenso können diamantähnliche Schichten, sogenannte i-C-Schichten, auf die Werkstücke aufgebracht werden, wenn eine Kohlenwasserstoffverbindung als Reaktivgas verwendet wird.

Zusätzlich kann der Entladungsbogen als Ionenquelle für die Zerstäubung von Atomen aus einer Kathode aus festem Material verwendet werden, wobei die unter Ionenbeschuß sich befindende Kathodenoberfläche aus dem zu zerstäubenden Material besteht. Die Kathode wird auf einem gegenüber der Anode der Bogenentladung negativen Potential gehalten, und an die zu behandelnden Werkstücke ist eine hochfrequente Wechselspannung oder eine gegenüber der Anode negative Spannung gelegt, so daß die Ablagerung der Ionen und neutralen Teilchen auf die Werkstückoberflächen möglich ist.

Alternativ hierzu kann der Entladungsbogen als Elektronenquelle für die Verdampfung von festen Materialien verwendet werden, wobei das zu verdampfende Material selbst als Anode der Bogenentladung dient. An die zu behandelnden Werkstücke ist wiederum hochfrequente Wechselspannung oder gegenüber der Anode der Bogenspannung negative Gleichspannung angelegt, so daß die Ablagerung der Ionen und neutralen Teilchen auf den Werkstückoberflächen möglich ist.

Mit Hilfe der erfindungsgemäßen Vorrichtung lassen sich auch metallische Schichten, nämlich aus dem Kathodenmaterial oder aus Verdampfungsprodukten, auf den Werkstückoberflächen aufbringen, die sich mit anderen Materialien, wie beispielsweise Reaktivgasen verbinden. Dadurch ergeben sich Schichten von beispielsweise Nitriden, Oxiden, Karbiden oder Boriden auf der Werkstückoberfläche. Es lassen sich also metallische Schichten mit Einlagerungen von anderen Materialien realisieren. Diese stammen beispielsweise aus der Ionisation in der Reaktivgaskammer oder aus der Ringöffnung der Magnetspulen.

Gemäß einer weiteren Ausführungsform der erfindungsgemäßen Vorrichtung sind auch die elektrisch isoliert von der Behandlungskammer angeordneten Gehäuse der Magnetspulen auf Schwebepotential gehalten.

Zur Erhöhung der Glühkathoden-Lebensdauer ist es erfindungsgemäß vorgesehen, die Glühkathode aus einer Wechselspannungsquelle und die Anode aus einer Gleichspannungsquelle mit Strom zu versorgen, wobei der negative Ausgang der Gleichstromquelle an ein Spannungsmittenpotential der Wechselspannungsquelle angeschlossen ist, vor allem an die sekundärseitige Mittenanzapfung eines Transformators der Wechselspannungsquelle, der sekundärseitig den Strom für die Glühkathode liefert.

Um einen kontinuierlichen Betrieb mit optimaler Elektronenemission zu gewährleisten, besteht die Glühkathode aus drei über Glühdrähte miteinander verbundene Elektroden, wobei die Mittenelektrode ständig und die beiden Außenelektroden wechselweise über Schalter an die Wechselspannungsquelle angeschlossen bzw. anschließbar sind. Im Betrieb ist jeweils vorzugsweise einer der Glühdrähte über ein Paar von Elektroden an die Spannungsquelle angeschlossen und der Widerstandswert dieses Glühdrahtes wird kontinuierlich mittels einer Widerstandsmeßeinrichtung überwacht, die bei Überschreiten eines vorbestimmten Widerstandsgrenzwertes dieses Glühdrahts die Wechselspannungsquelle auf den benachbarten Glühdraht umschaltet, bevor ein Durchschmelzen des ersten Glühdrahts erfolgt. Dadurch ist ein jederzeit sicherer Betrieb der erfindungsgemäßen Vorrichtung gewährleistet.

Um bei einseitiger Anordnung der Werkstücke gegenüber dem Ionenstrahl eine bevorzugte Richtung der Teilchenbewegung zu erzwingen, können Hilfselektroden in die Behandlungskammer eingebracht werden, die die Funktion von elektrischen Abschirmungen übernehmen. Übermäßiges Erhitzen der nahe am Entladungsbogen angebrachten Hilfselektroden läßt sich durch eine Kühlung dieser Elektroden vermeiden.

Der Gegenstand der Erfindung ist in den Fig. 1 bis 7 der Zeichnung anhand mehrerer bevorzugter Ausführungsbeipsiele dargestellt, welche nachstehend im einzelnen näher beschrieben sind. Es zeigen:
- Fig. 1: einen Axialschnitt durch die erfindungsgemäß ausgebildete Vorrichtung längs des einzigen Entladungsbogens;
- Fig. 2: einen Längsschnitt durch eine erfindungsgemäß ausgebildete Vorrichtung mit zwei Entladungsbögen;
- Fig. 3: eine Aufsicht auf eine erfindungsgemäß ausgebildete Vorrichtung mit drei Entladungsbögen in deren Mittenebene;
- Fig. 4: einen Axialschnitt entlang der Linien IV-IV in Fig. 3;
- Fig. 5: einen Schnitt durch eine Vorrichtung einer weiteren Ausführungsform;
- Fig. 6: einen Schnitt durch eine Ionisationskammer und Reaktivgaskammer der erfindungsgemäß ausgebildeten Vorrichtungen, und
- Fig. 7: einen Schnitt durch eine Vorrichtung zum kombinierten Ätzen und Beschichten von Werkstücken in einer weiteren Ausführungsform.

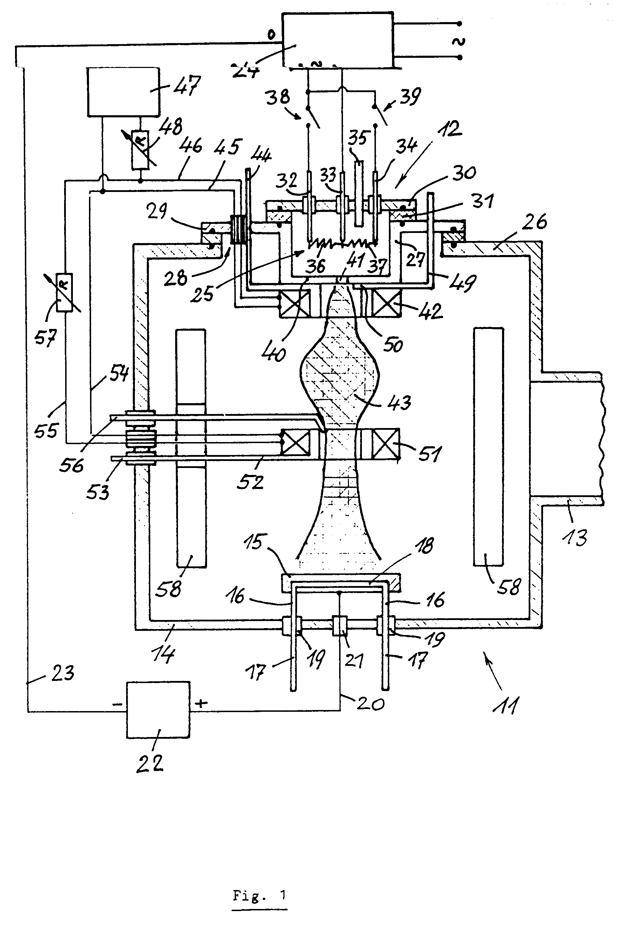

Die in Fig. 1 dargestellte Vorrichtung zur Oberflächenbehandlung von Werkstücken umfaßt eine vorzugsweise langgestreckte Behandlungskammer 11 sowie eine Ionisationskammer 12, die einen rechteckigen Querschnitt oder eine zylindrische Form aufweisen. Die Behandlungskammer 11 ist vakuumdicht gegen die Umgebung ausgelegt und mit einem Anschlußstutzen 13 versehen, der an eine Vakuumpumpe angeschlossen ist.

Oberhalb des Bodens 14 der Behandlungskammer 11 ist eine plattenförmige Anode 15 angeordnet. Die Anode 15 wird von den Standrohren 16 einer Kühlfluidleitung 17 getragen, welche innerhalb der Anode 15 als Kühlschlange 18 ausgebildet ist. Die Kühlfluidleitung 17 ist mittels der Dichtungselemente 19 durch den Boden 14 der Behandlungskammer 11 hindurchgeführt. Auch die elektrische Verbindungsleitung 20 zwischen dem Pluspol einer Gleichstromquelle 22 und der Anode 15 ist durch einen vakuumdichten Isolationskörper 21 hindurchgeführt. Der Minuspol der Gleichspannungsquelle 22 ist über die Leitung 23 mit dem Mittelabgriff eines nicht dargestellten Transformators einer Wechselspannungsquelle 24 verbunden. Diese Wechselspannungsquelle 24 dient der Stromversorgung der Glühkathode 25 in der Ionisationskammer 12, welche in den Deckel 26 der Behandlungskammer 11 eingesetzt ist.

Die Ionisationskammer 12 besteht aus einem topf- oder wannenförmigen Gehäuse 27, das durch die Öffnung 28 im Deckel 26 der Behandlungskammer 11 in diese hineinragt. Der periphere Flansch 29 des Gehäuses 27 liegt auf dem Rand der Öffnung 28 auf und ist diesem gegenüber elektrisch isoliert und mit diesem vakuumdicht verbunden.

Das Gehäuse 27 der Ionisationskammer 12 ist mittels des Deckels 30 unter Zwischenlage einer Isolierung 31 vakuumdicht verschlossen. Durch den Deckel 30 der Ionisationskammer 12 sind die drei Elektroden 32, 33 und 34 sowie ein Edelgaseinlaßstutzen 35 für das in der Ionisationskammer zu ionisierende Edelgas vakuumdicht hindurchgeführt. Zwischen den beiden äußeren Elektroden 32 und 34 und der Mittenelektrode 33 sind die Glühdrähte 36 und 37 angeordnet. Die Mittenelektrode 33 ist mit einem der beiden Wechselspannungsanschlüsse der Wechselspannungsquelle 24 verbunden; der andere Wechselspannungsanschluß ist über die beiden Schalter 38, 39 mit den äußeren Elektroden 32 bzw. 34 verbunden. Die Schalter 38 und 39 werden von einer nicht dargestellten Steuer- und Überwachungseinrichtung betätigt, welche den Ohm'schen Widerstand des bei geschlossenem Schalter 38 stromführenden Glühdrahts 36 kontinuierlich überwacht und nach Erreichen eines kritischen, oberen Wertes den Schalter 38 öffnet und gleichzeitig den Schalter 39 schließt, damit dann der zweite Glühdraht 37 von Strom durchflossen wird. Dadurch wird erreicht, daß in jedem Fall vor einem Durchschmelzen des ersten Glühdrahts, d.h. also mit der notwendigen Sicherheitsreserve, auf den zweiten, bislang nicht stromführenden Glühdraht umgeschaltet wird, der dann die Funktion der Elektronenemission übernimmt. Im Boden 40 des Gehäuses 27 befindet sich zentrisch eine Ionenstrahlaustrittöffnung 41 bzw. eine Lochblende, über welche die Ionisationskammer 12 mit der Behandlungskammer 11 verbunden ist. Unterhalb des Bodens 40 des Gehäuses 27 ist eine erste Magnetspule 42 angeordnet, deren Magnetfeld den aus der Ionisationskammer 12 in Richtung auf die gegenüberliegende Anode 15 austretenden Ionenstrom 42 ein erstes Mal einschnürt. Die erste Magnetspule 42 wird mittels eines von einem Kühlfluid durchströmten Kühlsystems 44 gekühlt. Die erste Magnetspule 42 ist über die elektrischen Leitungen 45 und 46 an eine Magnetspulen-Stromversorgung 47 angeschlossen. Die Anschlußleitungen 45 und 46 sind vakuumdicht durch den Gehäuseflansch 29 der Ionisationskammer 12 aus der Behandlungskammer 11 herausgeführt. In der Anschlußleitung 46 befindet sich in Reihe ein Stellwiderstand 48, mit dem der Strom zur Erregung des Magnetfeldes in der ersten Magnetspule 42 einstellbar ist. Mittels des Rohres 49, dessen Mündung 50 in der Nahe der Öffnung 41 im Boden 40 der Ionisationskammer 12 liegt, ist ein Reaktivgas in die Behandlungskammer einführbar.

Zwecks weiterer Einschnürung des Ionenstroms bzw. zur Steuerung der Ionendichte im Mittenbereich des Entladungsbogens 43 ist eine zweite Magnetspule 51 etwa mittig zwischen der ersten Magnetspule 42 und der Anode 15 angeordnet. Auch die zweite Magnetspule 51 wird mittels eines Kühlsystems 52 gekühlt. Die Kühlfluidleitungen 53, die elektrischen Leitungen 54, 55 zur Stromversorgung der zweiten Magnetspule 51 und die Reaktivgasleitung 56 sind vakuumdicht durch eine Seitenwand der Behandlungskammer 11 hindurchgeführt. Die Stromversorgung der zweiten Magnetspule 51 erfolgt mittels der Magnetspulen-Stromquelle 47. In der einen Verbindungsleitung 55 befindet sich ein Stellwiderstand 57 zwecks Einstellung der Stromstärke.

Die in Fig. 1 dargestellte Ätzvorrichtung ist vorzugsweise als Durchlaufanlage ausgelegt. Die Werkstücke 58 sind parallel zu den beiden Seitenwänden der Behandlungskammer in deren unmittelbarer Nähe und damit außerhalb des Magnetfeldes der ersten und der zweiten Magnetspule 42 und 51 angeordnet und können mit Hilfe nicht dargestellter Transportmittel durch die Behandlungskammer hindurchgeführt werden.

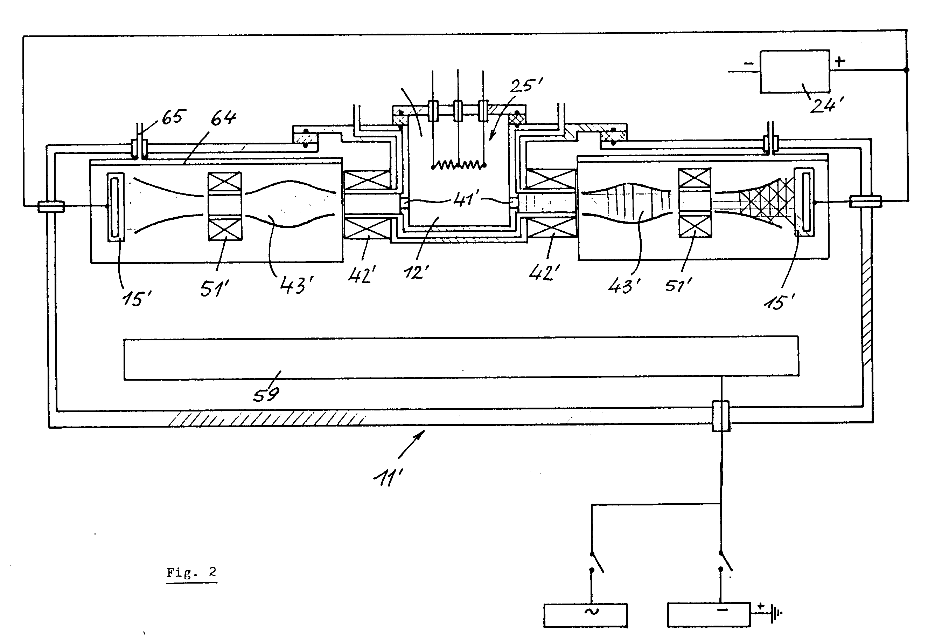

Die in Fig. 2 dargestellte Vorrichtung zur Oberflächenbehandlung von Werkstücken ist derart ausgebildet, daß in ihr zwei Niedervolt-Bogenentladungen stattfinden können, und zwar mittels einer einzigen Ionisationskammer 12', deren Aufbau der Ionisationskammer 12 nach Fig. 1 entspricht. Im Gegensatz zu letzterer weist diese zwei Ionenstrahlaustrittsöffnungen 41' auf, die an einander gegenübergelegenen Stellen in der Wandung des Gehäuses 27' der Ionisationskammer 12' angeordnet sind. Hinter einer jeden Ionenstrahlaustrittsöffnung 41' befinden sich axial zu diesen in einer gemeinsamen Ebene hintereinanderliegend eine erste Magnetspule 42' sowie eine zweite Magnetspule 51' und eine Anode 15', so daß sich beidseitig der Ionisationskammer 12' in der Längsrichtung der Behandlungskammer 11' liegende Entladungsbögen 43' ausbilden.

Die Vorrichtung gemäß Fig. 2 dient der einseitigen und vollflächigen Behandlung (Ätzen und bzw. oder Beschichten) größerer Werkstücke 59. Anstelle eines Werkstücks 59, dessen Länge knapp der Länge der Behandlungskammer 11' entsprechen kann, kann zur einseitigen Behandlung auch eine Vielzahl von kleineren Werkstücken in die Kammer 11' eingesetzt sein. Das Werkstück 59 ist an eine Hilfsspannungsquelle 60 oder 61 anschließbar, die außerhalb der Behandlungskammer 11' angeordnet ist. Der wahlweise Anschluß an die eine oder die andere Hilfsspannungsquelle 60 oder 61 erfolgt über entsprechende Schalter 62 bzw. 63. Die Hilfsspannungsquelle 60 liefert eine hochfrequente Wechselspannung an das Werkstück, während die Hilfsspannungsquelle 61 das Werkstück 59 mit einer Gleichspannung beaufschlagt, die relativ zum Anodenpotential negativ ausgelegt ist. Falls allseitige Behandlung gewünscht ist, ist eine Transporteinrichtung mit drehbarer Halterung vorzusehen.

Zwischen den Entladungsbögen 43' und der nächstgelegenen Wandung der Behandlungskammer 11' sind Elektrodenplatten 64 angeordnet, welche mittels eines Kühlfluids gekühlt werden, das Ober elektrisch isolierte Anschlußleitungen 65 den Platten 64 zugeführt wird.

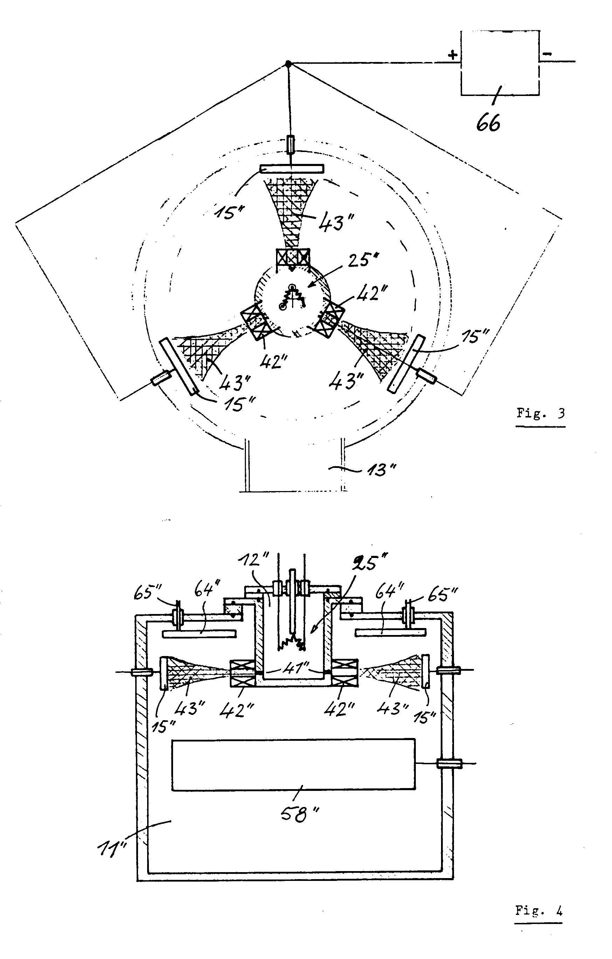

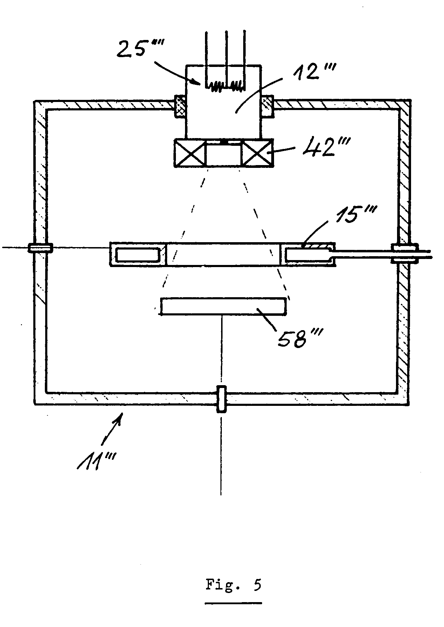

In den Figuren 3 und 4 ist eine Ätzvorrichtung mit einer zylindrischen Behandlungskammer 11'' dargestellt, bei welcher aus einer einzigen zentrisch angeordneten Ionisationskammer 12'' drei sich radial nach außen erstreckende Entladungsbögen 43'' erzeugt werden, die einen Winkelabstand von je 120° haben. Zur Erzeugung der drei Entladungsbögen 43'' gehört jeweils eine Magnetspule 42'' und eine zugeordnete Anode 15''. Die spannungsversorgung für alle drei Anoden 15'' erfolgt aus einer gemeinsamen Stromquelle 66.

Wie aus Fig. 4 hervorgeht, sind die Werkstücke 58'' in der zylindrischen Behandlungskammer 11'' unterhalb der Entladungsbögen 43'' zwischen diesen und dem Boden der Kammer angeordnet.

In Fig. 5 ist eine weitere Ausführungsform der Ätzvorrichtung dargestellt, die mit nur einer einzigen Magnetspule 42''' direkt unterhalb der Ionisationskammer 12''' ausgerüstet ist. Die ringförmige, gekühlte Anode 15''' befindet sich in etwa in der Mittelebene der Behandlungskammer. Das Werkstück 58''' ist in dem Raum unterhalb der gekühlten Ringanode 15''' angeordnet und elektisch leitend mit einer Hilfsspannungsquelle verbunden. Die Ringanode 15''' ist ebenso wie die Anoden 15 der Vorrichtungen nach den Figuren 1 bis 4 an eine nicht dargestellte Spannungsquelle angeschlossen; ihr wird über eine Fluidleitung 17''' ein Kühlfluid zugeführt.

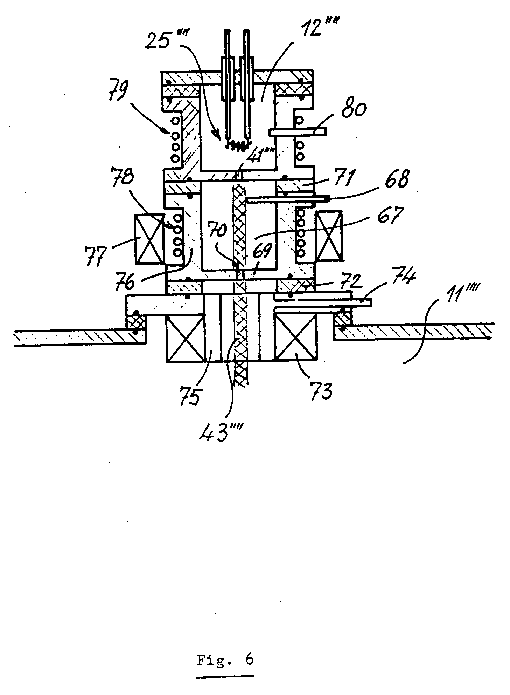

Bei der Ausführungsform nach Fig. 6 ist der Ionisationskammer 12''' eine Kammer 67 nachgeschaltet, in die mittels der Leitung 68 Reaktivgas eingleitet wird.

Die Reaktivgaskammer 67 weist in ihrem boden 69 eine Austrittsöffnung 70 für den Ionenstrahl auf. Die zylindrische Kammer 67 ist mittels der Isolierringe 71 und 72 einerseits gegenüber der Ionisationskammer 12'''' und andererseits gegenüber der Behandlungskammer 11'''' elektrisch isoliert. Unterhalb der Kammer 67 und innerhalb der Behandlungskammer 11'''' befindet sich die Magnetspule 73, die mittels Kühlfluid gekühlt wird, das über die Leitung 74 einem ringförmigen Kühlmantel 75 zugeführt wird, welcher auf der Innenseite der Magnetspule 42'''' angeordnet ist.

Den zylindrischen Mantel 76 der Kammer 67 umgibt eine Magnetspule 77, welcher die Funktion der Magnetspule 42 in Fig. 1 zukommt. Der Mantel 76 der Kammer 67 kann mittels einer von Kühlfluid durchströmten Kühlschlange 78 direkt gekühlt werden, die an der Außenfläche anliegt, oder durch direkte Wandkühlung, beispielsweise mittels einer Doppelwandung.

Das Gehäuse 27'''' der Ionisationskammer 12'''' kann gleichfalls mittels einer an deren Außenfläche anliegenden Kühlschlange 79 direkt gekühlt werden, oder durch direkte Wandkühlung, beispielsweise mittels einer Doppelwandung. Weiterhin kann in die Ionisationskammer 12'''' über eine Einlaßleitung 80 ein Edelgas eingeleitet werden. Die Bogenentladung erstreckt sich von dem Ionenstrahlaustritt 41'''' im boden 40'''' der Ionisationskammer 12'''' durch die Reaktivgaskammer 67 und die Öffnung 70 in deren Boden 69 hindurch in die Behandlungskammer 11'''' hinein bis zu der nicht dargestellten Anode.

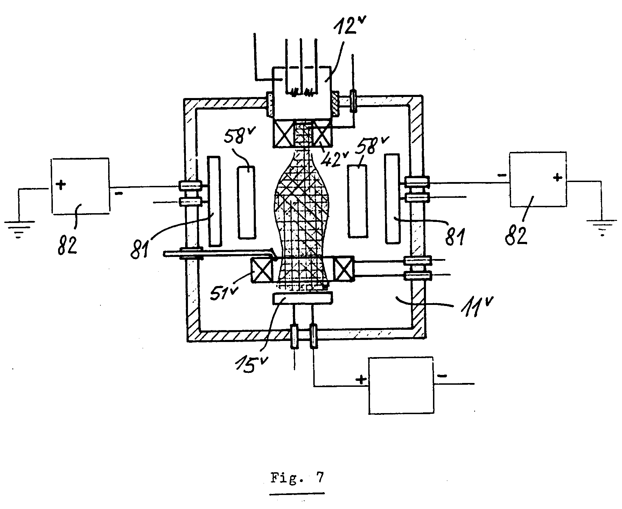

Bei dem Ausführungsbeispiel nach Fig. 7 entsprechen die Ionisationskammer 12^{v} und die Behandlungskammer 11^{v} im wesentlichen den entsprechenden Anlageteilen der Behandlungsvorrichtung nach Fig. 1. Zwischen den Werkstücken 58^{v} und den Seitenwänden der Behandlungskammer 11^{v} ist jeweils eine Zerstäubungskathode bzw. ein Magnetron 81 angeordnet, die an externe Stromquellen 82 angeschlossen sind. Diese Vorrichtung eignet sich ebenfalls als Durchlaufanlage, und zwar zur kombinierten Oberflächenbehandlung mittels Ionen aus dem Entladungsbogen sowie mit zerstäubtem Material von den Zerstäubungskathoden 81.

## Patentansprüche

1. Vorrichtung zur Oberflächenbehandlung, insbesondere zum Ätzen und/oder Beschichten von Werkstücken (58) mittels Ionenbeschuß, mit mindestens einer, eine Glühkathode (25) umfassenden Ionisationskammer (12), in die Gasatome zur Nieder-volt-Bogenentladung Zwischen Ionisationskammer (12) und mindestens einer Anode (15) in die Behandlungskammer (11) eingeleitet werden, die an eine Vakuumpumpe angeschlossen ist, und mit Wenigstens einer Magnetspule (42, 52, 73) zur Steuerung der Ionendichte in der Niedervolt-Bogen-entladung, wobei die Werkstücke (58) seitlich von einem Plasmastrom angeordnet sind, der durch die Wenigstens eine Magnetspule (42, 51, 73) gesteuert ist und wobei die wenigstens eine Magnetspule innerhalb der Behandlungskammer (11) angeordnet ist,
**dadurch kennzeichnet**, daß
a) während des Betriebs die zu behandelnden Werkstücke (58) radial außerhalb des starken Magnetfelds der wenigstens einen Magnetspule (42, 51, 73) in der Behandlungskammer (11) angeordnet sind, und
b) die Werkstücke derart in der Behandlungskammer (11) angeordnet sind, daß sie eine allseitige Oberflächenbehandlung erfahren.

2. Vorrichtung nach Anspruch 1, **gekennzeichnet** durch eine Anordnung von Magnetspulen (42, 51, 73) im Bereich der Bogenentladung Zwischen der Glühkathode (25) und der Anode (15), wobei die Magnetspulenachsen im wesentlichen mit der Bogenentladungsmittelachse Zusammenfallen.

3. Vorrichtung nach Anspruch 1 oder 2, dadurch **gekennzeichnet**, daß die Werkstücke (58) in der Nähe der Wand bzw. der Wände der Behandlungskammer (11) angeordnet sind.

4. Vorrichtung nach einem der Ansprüche 1 bis 3, **gekennzeichnet** durch eine erste Magnetspule (42), die in Richtung auf die Anode (15) unmittelbar hinter der Ionenstrahlaustrittsöffnung (41) im Gehäuse (27) der Ionisationskammer (12) angeordnet ist und wenigstens eine Zweite Magnetspule (51), die zwischen der ersten Magnetspule (42) und der Anode (15) angeordnet ist.

5. Vorrichtung nach einem der Ansprüche 1 bis 4, **gekennzeichnet** durch eine Ionisationskammer (12) mit wenigstens zwei Ionenstrahlaustrittsöffnungen (41), welchen jeweils axial gegenüberliegend eine Anode (15) angeordnet ist.

6. Vorrichtung nach einem der Ansprüche 1 bis 5, dadurch **gekennzeichnet**, daß die Magnetspulen (42, 51, 73) axial verschiebbar angeordnet sind.

7. Vorrichtung nach einem der Ansprüche 1 bis 6, dadurch **gekennzeichnet**, daß die Stromquellen (47) für die Magnetspulen (42, 51, 73) eine hohe Ausgangsimpedanz haben und daß ihre Stromstärke regelbar ist.

8. Vorrichtung nach einem der Ansprüche 1 bis 7, **gekennzeichnet** durch den Anschluß einer regelbaren Hilfsspannung an die zu behandelnden Werkstücke (58).

9. Vorrichtung nach Anspruch 8, dadurch **gekennzeichnet**, daß die Hilfsspannung eine hochfrequente Wechselspannung ist.

10. Vorrichtung nach Anspruch 8, dadurch **gekennzeichnet**, daß die Hilfsspannung eine relativ zum Anodenpotential negative Gleichspannung ist.

11. Vorrichtung nach einem der Ansprüche 1 bis 10, dadurch **gekennzeichnet**, daß die Anode (15) als wassergekühlte Ringanode (15''') ausgebildet ist und die Werkstücke (58''') in der Bewegungsrichtung des Ionenstrahls (42''') unterhalb bzw. hinter der Ringanode (15''') angeordnet sind (Fig. 5).

12. Vorrichtung nach einem der Ansprüche 1 bis 11 mit einer Anordnung zur Einbringung eines Reaktivgases oder Reaktivgasgemischs in die Behandlungskammer (11), dadurch **gekennzeichnet**, daß die Zuführleitungen (49, 56) für das Reaktivgas in den Innenraum der Magnetspulen (42, 51) einmünden.

13. Vorrichtung nach Anspruch 12, dadurch **gekennzeichnet**, daß die Reaktivgas-Zuführleitung (49) zum Innenraum der ersten Magnetspule (42) in unmittelbarer Nähe der Ionenstrahlaustrittsöffnung (41) der Ionisationskammer (12) mündet.

14. Vorrichtung nach einem oder mehreren der Ansprüche 1 bis 11, **gekennzeichnet** durch eine der Ionisationskammer (12) nachgeschaltete, von einer ersten Magnetspule (77) umgebenen Reaktivgaskammer (67) mit einer Einlaßleitung (68) für das Reaktivgas und eine zweite Magnetspule im Bereich einer Mischionenstrahl-Auslaßöffnung (70) wobei der Gasdruck in der Reaktivgaskammer (67) niedriger gehalten ist als in der Ionisationskammer (12) und höher als in der Behandlungskammer (11).

15. Vorrichtung nach einem der Ansprüche 1 bis 14, **gekennzeichnet** durch ein Wechselstromversorgungsteil (24) für die Glühkathode (25) und ein Gleichstromversorgungsteil (22) für die Anode (15), wobei der negative Ausgang des Gleichstromversorgungsteils (22) an ein Spannungs-Mittenpotential des Wechselstromversorgungsteils (24) für die Glühkathode (25), vor allem an die sekundärseitige Mittelanzapfung eines Transformators dieses Teils angeschlossen ist.

16. Vorrichtung nach Anspruch 15, dadurch **gekennzeichnet**, daß die Glühkathode (25) drei über Glühdrähte (36, 37) miteinander verbundene Elektroden (32, 33, 34) umfaßt, wobei die Mittenelektrode (33) ständig und die beiden Außenelektroden (32 u. 34) wechselweise über Schalter (38, 39) an das Wechselstromversorgungsteil (24) angeschlossen bzw. anschließbar sind.

17. Vorrichtung nach Anspruch 16, **gekennzeichnet** durch eine die beiden Anschlußschalter (38, 39) in Abhängigkeit vom Ohm'schen Widerstand der Glühdrähte (36, 37) tätigende Meß- und Steuereinrichtung, welche bei Überschreiten eines vorbestimmten Widerstands-Grenzwertes des stromdurchflossenen Glühdrahtes den Anschlußschalter der zugehörigen Außenelektrode öffnet und den Anschlußschalter der anderen Außenelektrode schließt.

## Claims

1. Apparatus for surface treatment, in particular for etching and/or coating workpieces (58) by means of ion bombardment, the apparatus having at least one ionisation chamber (12) surrounding a glow cathode (25), in which ionisation chamber (12) gas atoms for low-voltage arc discharge between the ionisation chamber (12) and at least one anode (15) are introduced into the treatment chamber (11) which is connected to a vacuum pump, and at least one magnetic coil (42, 52, 73) for controlling ion density in the low-voltage arc discharge, with the workpieces (58) being arranged on the side of a plasma current which is controlled by the at least one magnetic coil (42, 51, 73) and with the at least one magnetic coil being arranged within the treatment chamber (11), characterised in that
a) during operation, the workpieces (58) to be treated are arranged radially outside the strong magnetic field of the at least one magnetic coil (42, 51, 73) in the treatment chamber (11) and
b) the workpieces are arranged in the treatment chamber (11) such that they undergo surface treatment on all sides.

2. Apparatus according to claim 1, characterised by an arrangement of magnetic coils (42, 51, 73) in the region of the arc discharge between the glow cathode (25) and the anode (15), wherein the magnetic coil axes coincide substantially with the arc discharge central axis.

3. Apparatus according to claim 1 or 2, characterised in that the workpieces (58) are arranged in the vicinity of the wall or of the walls of the treatment chamber (11).

4. Apparatus according to one of claims 1 to 3, characterised by a first magnetic coil (42), which is arranged in the direction of the anode (15) directly behind the ion beam outlet opening (41) in the housing (27) of the ionisation chamber (12) and at least one second magnetic coil (51) which is arranged between the first magnetic coil (42) and the anode (15).

5. Apparatus according to one of claims 1 to 4, characterised by an ionisation chamber (12) with at least two ion beam outlet openings (41), each of which is arranged axially opposed to an anode (15).

6. Apparatus according to one of claims 1 to 5, characterised in that the magnetic coils (42, 51, 73) are arranged in an axially displaceable manner.

7. Apparatus according to one of claims 1 to 6, characterised in that the current sources (47) for the magnetic coils (42, 51, 73) have a high output impedance and that their current strength is able to be controlled.

8. Apparatus according to one of claims 1 to 7, characterised by the connection of a controllable auxiliary voltage to the workpieces to be treated (58).

9. Apparatus according to claim 8, characterised in that the auxiliary voltage is a high-frequency alternating voltage.

10. Apparatus according to claim 8, characterised in that the auxiliary voltage is a negative direct voltage relative to the anode potential.

11. Apparatus according to one of claims 1 to 10, characterised in that the anode (15) is formed as a water-cooled annular anode (15''') and the workpieces (58''') are arranged in the direction of movement of the ion beam (42''') below or behind the annular anode (15''') (Figure 5).

12. Apparatus according to one of claims 1 to 11, having an arrangement for introducing a reactive gas or a reactive gas mixture into the treatment chamber (11), characterised in that the supply lines (49, 56) for the reactive gas open into the inner chamber of the magnetic coils (42, 51).

13. Apparatus according to claim 12, characterised in that the reactive gas supply line (49) to the inner chamber of the first magnetic coil (42) opens in the immediate vicinity of the ion beam outlet opening (41) of the ionisation chamber (12).

14. Apparatus according to one or more of claims 1 to 11, characterised by a reactive gas chamber (67), connected after the ionisation chamber (12) and surrounded by a first magnetic coil (77), the chamber having an inlet line (68) for the reactive gas, and by a second magnetic coil in the region of a mixed ion beam outlet opening (70), with the gas pressure in the reactive gas chamber (67) being kept lower than in the ionisation chamber (12) and higher than in the treatment chamber (11).

15. Apparatus according to one of claims 1 to 14 characterised by an alternating current supply part (24) for the glow cathode (25) and a direct current supply part (22) for the anode (15), with the negative output of the direct-current supply part (22) being connected to a voltage average potential of the alternating current supply part (24) for the glow cathode (25), in particular to the secondary side central tapping of a transformer of this part.

16. Apparatus according to claim 15, characterised in that the glow cathode (25) comprises three electrodes (32, 33, 34) connected with each other by way of glow wires (36, 37), with the central electrode (33) being connected or able to be connected permanently to the alternating current supply part (24) and the two outer electrodes (32 and 34) being connected or able to be connected to the alternating current supply part (24) alternately by way of switches (38, 39).

17. Apparatus according to claim 16, characterised by a measuring and control device activating the two connecting switches (38, 39) in dependence on the high ohmic resistance of the glow wires (36, 37), which, when a predetermined resistance boundary value of the glow wire carrying current is exceeded, opens the connection switch of the associated outer electrode and closes the connection switch of the other outer electrode.

## Revendications

1. Dispositif de traitement de surface, en particulier pour l'attaque chimique et/ou le revêtement de pièces (58) au moyen d'un bombardement ionique, comprenant au moins une chambre d'ionisation (12) qui contient une cathode incandescente (25) et dans laquelle des atomes de gaz sont introduits pour provoquer une décharge par arc à basse tension, entre la chambre d'ionisation (12) et au moins une anode (15), dans la chambre de traitement (11) qui est reliée à une pompe à vide, et comprenant au moins une bobine d'électro-aimant (42, 52, 73) pour réguler la densité ionique de la décharge par arc à basse tension, les pièces (58) étant disposées à côté d'un flux de plasma qui est régulé par la bobine d'électro-aimant (42, 51, 73) au nombre d'au moins une, et la bobine d'électro-aimant au nombre d'au moins une étant disposée à l'intérieur de la chambre de traitement (11), **caractérisé en ce que**,
a) au cours du fonctionnement, les pièces (58) que l'on veut traiter sont disposées dans la chambre de traitement (11) radialement à l'extérieur du champ magnétique puissant de la bobine d'électro-aimant (42, 51, 73) au nombre d'au moins une, et
b) les pièces sont disposées dans la chambre de traitement (11) de façon à subir un traitement de surface sur tous les côtés.

2. Dispositif selon la revendication 1, **caractérisé en ce que** des bobines d'électro-aimant (52, 51, 73) sont disposées dans la zone de la décharge par arc entre la cathode incandescente (25) et l'anode (15), les axes des bobines d'électro-aimant coïncidant sensiblement avec l'axe médian de la décharge par arc.

3. Dispositif selon la revendication 1 OU 2, **caractérisé en ce que** les pièces (58) sont disposées à proximité de la ou des parois de la chambre de traitement (11).

4. Dispositif selon l'une des revendications 1 à 3, **caractérisé** par une première bobine d'électro-aimant (42) qui est disposée, en direction de l'anode (15), juste derrière l'ouverture (41) de sortie du faisceau ionique pratiquée dans l'enceinte (27) de la chambre d'ionisation (12), et par au moins une seconde bobine d'électro-aimant (51) qui est disposée entre la première bobine d'électroaimant (42) et l'anode (15).

5. Dispositif selon l'une des revendications 1 à 4, **caractérisé** par une chambre d'ionisation (12) comprenant au moins deux ouvertures (41) de sortie du faisceau ionique, en face de chacune desquelles une anode (15) est disposée axialement.

6. Dispositif selon l'une des revendications 1 à 5, **caractérisé en ce que** les bobines d'électro-aimant (42, 51, 73) sont disposées de façon à pouvoir coulisser axialement.

7. Dispositif selon l'une des revendications 1 à 6, **caractérisé en ce que** les sources de courant (47) destinées aux bobines d'électro-aimant (42, 51, 73) ont une impédance de sortie élevée, et en ce que leur intensité de courant est réglable.

8. Dispositif selon l'une des revendications 1 à 7, **caractérisé en ce qu**'une tension auxiliaire réglable est reliée aux pièces (58) que l'on veut traiter.

9. Dispositif selon la revendication 8, **caractérisé en ce que** la tension auxiliaire est une tension alternative à haute fréquence.

10. Dispositif selon la revendication 8, **caractérisé en ce que** la tension auxiliaire est une tension continue négative par rapport au potentiel de l'anode.

11. Dispositif selon l'une des revendications 1 à 10, **caractérisé en ce que** l'anode (15) est conçue sous la forme d'une anode annulaire (15''') refroidie par eau, et les pièces (58''') sont disposées sous ou derrière l'anode annulaire (15''') par rapport au sens de déplacement du faisceau ionique (42''') (figure 5).

12. Dispositif selon l'une des revendications 1 à 11, comprenant un agencement pour introduire un gaz réactif ou un mélange de gaz réactifs dans la chambre de traitement (11), **caractérisé en ce que** les conduites d'alimentation (49, 56) en gaz réactif débouchent dans l'espace intérieur des bobines d'électro-aimant (42, 51).

13. Dispositif selon la revendication 12, **caractérisé en ce que** la conduite d'alimentation (49) en gaz réactif reliée à l'espace intérieur de la première bobine d'électro-aimant (42) débouche à proximité immédiate de l'ouverture (41) de sortie du faisceau ionique de la chambre d'ionisation (12).

14. Dispositif selon une ou plusieurs des revendications 1 à 11, **caractérisé** par une chambre à gaz réactifs (67) qui succède à la chambre d'ionisation (12), qui est entourée par une première bobine d'électro-aimant (77) et qui est pourvue d'une conduite d'admission (68) pour le gaz réactif, et par une seconde bobine d'électro-aimant disposée dans la zone d'une ouverture de sortie (70) du faisceau ionique mixte, la pression de gaz dans la chambre à gaz réactifs (67) étant maintenue inférieure à celle de la chambre d'ionisation (12) et supérieure à celle de la chambre de traitement (11).

15. Dispositif selon l'une des revendications 1 à 14, **caractérisé** par un bloc d'alimentation en courant alternatif (24) pour la cathode incandescente (25) et par un bloc d'alimentation en courant continu (22) pour l'anode (15), la sortie négative du bloc d'alimentation en courant continu (22) étant connectée à un potentiel médian de tension du bloc d'alimentation en courant alternatif (24) pour la cathode incandescente (25), surtout à la prise médiane secondaire d'un transformateur de ce bloc.

16. Dispositif selon la revendication 15, **caractérisé en ce que** la cathode incandescente (25) comprend trois électrodes (32, 33, 34) reliées entre elles par des filaments chauffants (36, 37), l'électrode centrale (33) étant connectée en permanence au bloc d'alimentation en courant alternatif (24) et les deux électrodes extérieures (32 et 34) pouvant y être connectées en alternance par l'intermédiaire de commutateurs (38, 39).

17. Dispositif selon la revendication 16, **caractérisé** par un système de mesure et de commande qui actionne les deux commutateurs de connexion (38, 39) en fonction de la résistance ohmique des filaments chauffants (36, 37) et qui, en cas de dépassement d'une valeur limite prédéterminée de résistance du filament chauffant parcouru par le courant, ouvre le commutateur de connexion de l'électrode extérieure correspondante et ferme le commutateur de connexion de l'autre électrode extérieure.
